# EUROPEAN PATENT APPLICATION

(11) **EP 3 358 617 A1**
(43) Date of publication of application: **08.08.2018**
(21) Application number: 18154661.5
(22) Date of filing: 01.02.2018
(51) Int. Cl.: H01L 23/485, H01L 23/488, H01L 21/60, H01L 27/105

(54) **SEMICONDUCTOR DEVICE WITH SUBSTANTIALLY EQUAL TENSILE FORCES ACTING ON CHIP SURFACES**

(30) Priority: 02.02.2017 JP 2017017827
(71) Applicant: JTEKT Corporation, Osaka-shi, Osaka 542-8502 (JP)
(72) Inventor: TANI, Naoki, Osaka-shi, Osaka 542-8502 (JP)
(74) Representative: Winter, Brandl, Fürniss, Hübner, Röss, Kaiser, Polte - Partnerschaft mbB

(57) **Abstract**

An electrode surface (32a, 35a) of a horizontal semiconductor chip (32, 35) and a substrate (31) are joined together through a plurality of first joint portions (50, 70) including a plurality of joint portions (7, 51, 71) at which a plurality of electrodes (D, S, G) formed on the electrode surface (32a, 35a) are joined to the substrate (31). A no-electrode surface (32b, 35b) of the horizontal semiconductor chip (32, 35) and a heatsink (33) are joined together through a second joint portion (8) at which the no-electrode surface (32b, 35b) and the heatsink (33) are joined together. In a plan view from a direction normal to a principal surface of the substrate (31), the region defined by the outline of a rough shape of an aggregate of the first joint portions (50, 70) and the region defined by the outline of the second joint portion (8) are the same in position, shape, and size. Accordingly, the tensile forces acting on the no-electrode surface (32b, 35b) and the electrode surface (32a, 35a) of the horizontal semiconductor chip (32, 35) are substantially equal. Thus, warping of the horizontal semiconductor chip (32, 35) can be suppressed.

The first joint portions (50, 70) may optionally include one or more dummy joint portions (52, 53, 54, 72, 73, 74) at which the electrode surface (32a, 35a) and the substrate (31) are joined together, without electrical connection of the chip electrodes to the circuit wiring of the substrate (31) at the dummy joint portions (52, 53, 54, 72, 73, 74).

## Description

### BACKGROUND OF THE INVENTION

### 1. Field of the Invention

The present invention relates to a semiconductor device that is used, for example, for an inverter circuit of an electric power steering system.

### 2. Description of the Related Art

In an inverter circuit of an electric power steering system, a switching element may produce heat rapidly in a short time. Therefore, a structure with a heatsink joined to a back surface of a substrate to which the switching element is joined is adopted so that the heat produced by the switching element is absorbed by the heatsink.

A vertical semiconductor element having a drain electrode (or a collector electrode) provided on one surface and a source electrode (or an emitter electrode) and a gate electrode (or a base electrode) provided on the other surface has been hitherto commonly used as a switching element (see Japanese Patent Application Publication No. 2012-99612 (JP 2012-99612 A)). It is conceivable to use, as a switching element, a horizontal semiconductor element that has a drain electrode (or a collector electrode), a source electrode (or an emitter electrode), and a gate electrode (or a base electrode) provided on one surface and no electrodes provided on the other surface. When such a horizontal semiconductor element is used as a switching element, the area of the electrodes provided on one surface is smaller than the area of the electrodes in the vertical semiconductor chip. Accordingly, the thermal resistance of one surface of the horizontal semiconductor element on which the electrodes are provided (hereinafter may be referred to as an electrode surface) is higher than the thermal resistance of the surface of the vertical semiconductor element on which the drain electrode (or the collector electrode) is provided. Therefore, using the horizontal semiconductor element as a switching element requires adopting a structure in which electrical connection is provided on the electrode surface and heat is dissipated from the other surface on which no electrodes are provided (hereinafter may be referred to as a no-electrode surface).

Thus, to use the horizontal semiconductor element as a switching element, it is conceivable to join the electrodes to the substrate through solder, for example, with the electrode surface facing a surface of the substrate, and join a heatsink to the no-electrode surface through solder, for example. However, as the linear thermal expansion coefficients of the heatsink and the substrate and the linear thermal expansion coefficient of the horizontal semiconductor element are significantly different from each other, the horizontal semiconductor chip may warp due to the difference in thermal expansion. Any warping of the horizontal semiconductor element will cause stress on the joint portion between the horizontal semiconductor element and the substrate and on the joint portion between the horizontal semiconductor element and the heatsink. This may result in electrical connection failure at the joint portion between the horizontal semiconductor element and the substrate, or thermal connection failure at the joint portion between the horizontal semiconductor element and the heatsink.

In this specification, a semiconductor chip that includes one or more semiconductor elements, and has electrodes provided on one surface and no electrodes provided on the other surface will be hereinafter referred to as a horizontal semiconductor chip. Of the two surfaces of the horizontal semiconductor chip, the surface on which the electrodes are provided will be referred to as an electrode surface, and the other surface on which no electrodes are provided will be referred to as a no-electrode surface.

### SUMMARY OF THE INVENTION

It is an object of the present invention to provide a semiconductor device that can prevent connection failure at a joint portion between a horizontal semiconductor chip and a substrate and a joint portion between the horizontal semiconductor chip and a heat dissipation member.

According to a first embodiment of the present invention, the semiconductor device includes: a substrate; a horizontal semiconductor chip that has an electrode surface on which a plurality of electrodes are provided and a no-electrode surface which is a surface on the opposite side from the electrode surface and on which no electrodes are provided, and the horizontal semiconductor chip is joined to the substrate with the electrode surface facing one surface of the substrate; and a heat dissipation member which is disposed on the opposite side of the horizontal semiconductor chip from the substrate, and to which at least a part of the no-electrode surface of the horizontal semiconductor chip is joined. The electrode surface and the substrate are joined together through a plurality of first joint portions including at least a plurality of joint portions at which the electrodes formed on the electrode surface are joined to the substrate. The no-electrode surface and the heat dissipation member are joined together through a second joint portion at which the no-electrode surface and the heat dissipation member are joined together. In a plan view from a direction normal to a principal surface of the substrate, when a region inside the outline of the rough overall shape of an aggregate of the first joint portions is a first joint region and a region inside the outline of the second joint portion is a second joint region, the first joint region and the second joint region are the same in position, shape, and size.

### BRIEF DESCRIPTION OF THE DRAWINGS

The foregoing and further features and advantages of the invention will become apparent from the following description of example embodiments with reference to the accompanying drawings, wherein like numerals are used to represent like elements and wherein:
FIG. 1 is a sectional view schematically showing the configuration of an electromechanical integral motor unit to which a semiconductor device according to a first embodiment of the present invention is applied;
FIG. 2 is an electric circuit diagram showing an inverter circuit;
FIG. 3 is a plan view, as seen from a no-electrode surface side, of electrodes that are formed on an electrode surface of a horizontal semiconductor chip;
FIG. 4 is an enlarged front view showing a joint structure of a substrate and the horizontal semiconductor chip and a joint structure of the horizontal semiconductor chip and a heatsink;
FIG. 5 is a sectional view taken along the line V-V of FIG. 4;
FIG. 6 is a sectional view taken along the line VI-VI of FIG. 4;
FIG. 7 is a sectional view, corresponding to FIG. 5, showing a modified example of the joint structure of the substrate and the horizontal semiconductor chip;
FIG. 8 is an enlarged sectional view, taken along the line VIII-VIII of FIG. 9, showing a modified example of the joint structure of the substrate and the horizontal semiconductor chip and the joint structure of the horizontal semiconductor chip and the heatsink;
FIG. 9 is a sectional view taken along the line IX-IX of FIG. 8;
FIG. 10 is a sectional view taken along the line X-X of FIG. 8;
FIG. 11 is a plan view, as seen from a no-electrode surface side, of electrodes formed on an electrode surface of a horizontal semiconductor chip that is composed of one switching element;
FIG. 12 is an enlarged front view showing a joint structure of the substrate and the horizontal semiconductor chip and a joint structure of the horizontal semiconductor chip and the heatsink;
FIG. 13 is a sectional view taken along the line XIII-XIII of FIG. 12;
FIG. 14 is a sectional view taken along the line XIV-XIV of FIG. 12;
FIG. 15 is a sectional view, corresponding to FIG. 13, showing a modified example of the joint structure of the substrate and the horizontal semiconductor chip;
FIG. 16 is an enlarged sectional view, taken along the line XVI-XVI of FIG. 17, showing a modified example of the joint structure of the substrate and the horizontal semiconductor chip and the joint structure of the horizontal semiconductor chip and the heatsink;
FIG. 17 is a sectional view taken along the line XVII-XVII of FIG. 16; and
FIG. 18 is a sectional view taken along the line XVIII-XVIII of FIG. 16.

### DETAILED DESCRIPTION OF EMBODIMENTS

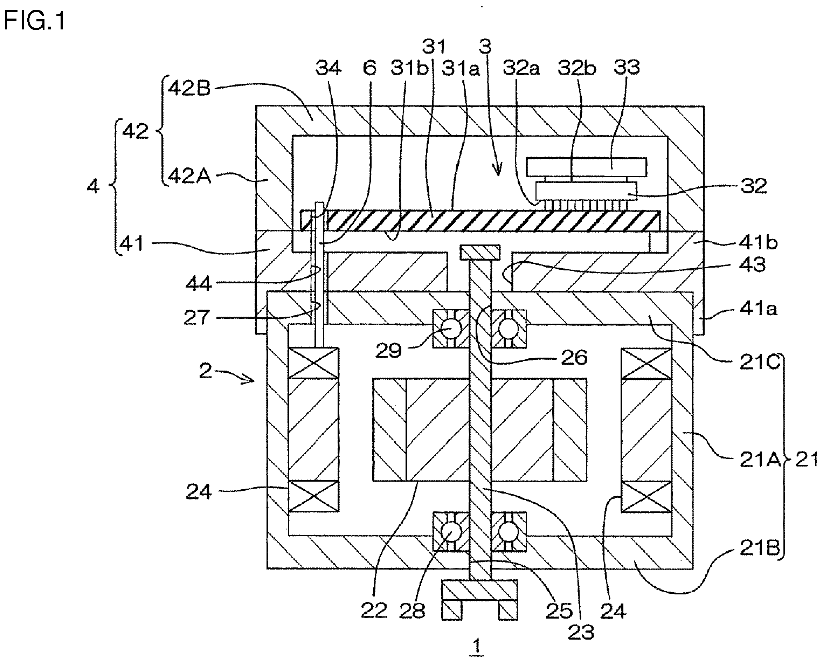

Embodiments of the present invention will be described below in detail with reference to the accompanying drawings. FIG. 1 is a sectional view schematically showing the configuration of an electromechanical integral motor unit to which a semiconductor device according to a first embodiment of the present invention is applied. The electromechanical integral motor unit 1 is a unit that is, for example, incorporated in an electric power steering system for a vehicle. The electromechanical integral motor unit 1 includes an electric motor 2, a power module 3, and a case 4. The power module 3 realizes a driving circuit of the electric motor 2. The case 4 houses the power module 3.

The electric motor 2 includes a motor housing 21, a rotor 22, a rotor shaft 23, and a stator 24. The motor housing 21 has a columnar shape, and is composed of a cylindrical side wall 21A, a bottom wall 21B, and a top wall 21C. The bottom wall 21B closes a lower opening of the side wall 21A. The top wall 21C closes an upper opening of the side wall 21A. The bottom wall 21B and the top wall 21C respectively have rotor shaft insertion holes 25, 26 formed at center portions thereof. The top wall 21C further has a bus bar insertion hole 27 formed therein.

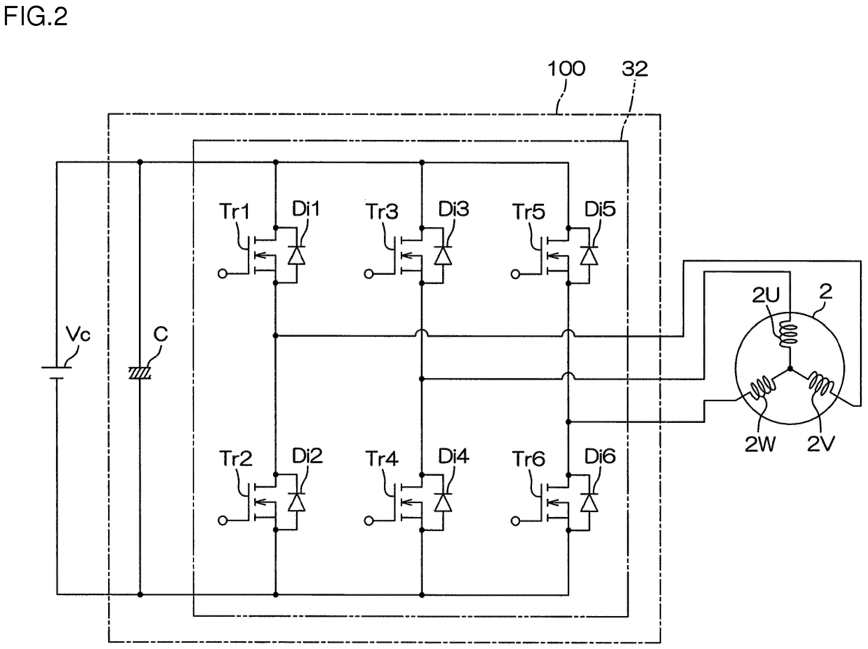

The rotor shaft 23 is fixed to the rotor 22 while extending through a center portion of the rotor 22. A lower end of the rotor shaft 23passes through the rotor shaft insertion hole 25 of the bottom wall 21B, while an upper end of the rotor shaft 23 passes through the rotor shaft insertion hole 26 of the top wall 21C. The rotor shaft 23 is supported on the motor housing 21 by a bearing 28 and a bearing 29 so as to be rotatable relative to the motor housing 21. The bearing 28 is mounted on the bottom wall 21B of the motor housing 21. The bearing 29 is mounted on the top wall 21C. The stator 24 is mounted on the side wall 21A of the motor housing 21. The stator 24 includes stator windings 2U, 2V, 2W (see FIG. 2).

The case 4 is composed of a disc-shaped bottom plate 41 that is disposed on the top wall 21C of the motor housing 21, and a cover 42 that is disposed on an upper side of the bottom plate 41. An annular lower protrusion 41a is formed at an outer circumferential edge of a lower surface of the bottom plate 41. An annular upper protrusion 41b is formed at an outer circumferential edge of an upper surface of the bottom plate 41. The bottom plate 41 is fixed to the top wall 21C with the lower protrusion 41a fitted on an outer circumferential surface of an upper end of the motor housing 21. The bottom plate 41 has a rotor shaft insertion hole 43 formed at a center portion thereof, and the upper end of the rotor shaft 23 passes through the rotor shaft insertion hole 43. The bottom plate 41 has a bus bar insertion hole 44 formed therein that communicates with the bus bar insertion hole 27 of the top wall 21C.

The cover 42 is composed of a cylindrical side wall 42A and a top wall 42B that closes an upper opening of the side wall 42A. The cover 42 is fixed to the bottom plate 41 with the side wall 42A placed on the upper protrusion 41b of the bottom plate 41. The power module 3 is a module for realizing an inverter circuit 100 for an electric power steering (EPS) system as shown in FIG. 2. The inverter circuit 100 shown in FIG. 2 includes a horizontal semiconductor chip 32 and a smoothing capacitor C. The smoothing capacitor C is connected between terminals of a power source Vc. The horizontal semiconductor chip 32 includes a plurality of switching elements Tr1 to Tr6.

The switching elements Tr1 to Tr6 include: a first switching element Tr1 for a high side of a V-phase; a second switching element Tr2 for a low side of the V-phase that is connected in series with the first switching element Tr1; a third switching element Tr3 for a high side of a U-phase; a fourth switching element Tr4 for a low side of the U-phase that is connected in series with the third switching element Tr3; a fifth switching element Tr5 for a high side of a W-phase; and a sixth switching element Tr6 for a low side of the W-phase that is connected in series with the fifth switching element Tr5. In this embodiment, the switching elements Tr1 to Tr6 are GaN-FETs (FET: Field Effect Transistor) composed mainly of GaN. First to sixth diode elements Di1 to Di6 are connected in inverse-parallel to the first to sixth switching elements Tr1 to Tr6, respectively. The diode elements Di1 to Di6 are also included in the horizontal semiconductor chip 32.

Drains of the first, third, and fifth switching elements Tr1, Tr3, Tr5 are connected to a positive-electrode terminal of the power source Vc. Sources of the first, third, and fifth switching elements Tr1, Tr3, Tr5 are respectively connected to drains of the second, fourth, and sixth switching elements Tr2, Tr4, Tr6. Sources of the second, fourth, and sixth switching elements Tr2, Tr4, Tr6 are connected to a negative-electrode terminal of the power source Vc.

A connection point between the first switching element Tr1 and the second switching element Tr2 is connected to the V-phase stator winding 2V of the electric motor 2. A connection point between the third switching element Tr3 and the fourth switching element Tr4 is connected to the U-phase stator winding 2U of the electric motor 2. A connection point between the fifth switching element Tr5 and the sixth switching element Tr6 is connected to the W-phase stator winding 2W of the electric motor 2. Gates of the switching elements Tr1 to Tr6 are connected to a motor control circuit (not shown).

Referring to FIG. 1 and FIG. 2, the power module 3 includes a substrate 31, the horizontal semiconductor chip 32, and a heatsink (heat dissipation member) 33. The substrate 31 is fixed to the bottom plate 41 of the case 4 through a mounting member. An electrode surface 32a joined to the substrate 31 is joined to the horizontal semiconductor chip 32. The heatsink 33 is joined to a no-electrode surface 32b of the horizontal semiconductor chip 32. The heatsink 33 is made of copper in this embodiment. Although the power module 3 includes the smoothing capacitor C shown in FIG. 2, the smoothing capacitor C is omitted from FIG. 1 for the convenience of description.

The substrate 31 has a first principal surface (the upper surface in FIG. 1) 31a, and a second principal surface (the lower surface in FIG. 1) 31b on the opposite side from the first principal surface 31a. In a plan view seen from a direction normal to the principal surfaces 31a, 31b, the substrate 31 has a circular shape and is slightly smaller than the case 4. The substrate 31 is a ceramic substrate in this embodiment. However, the substrate 31 may be a substrate other than a ceramic substrate, for example, a glass epoxy substrate. Wiring (not shown) that forms the inverter circuit 100 is formed on the first principal surface 31a of the substrate 31. The horizontal semiconductor chip 32 and the smoothing capacitor C (not shown in FIG. 1) are mounted on the first principal surface 31a of the substrate 31.

The substrate 31 has a bus bar insertion hole 34 formed therein at a position facing the bus bar insertion hole 44 of the bottom plate 41. The stator windings 2U, 2V, 2W of the stator 24 are respectively connected to a wiring pattern formed on the first principal surface 31a of the substrate 31 through bus bars. Only one bus bar 6 of these bus bars is shown in FIG. 1. The bus bar 6 passes through the bus bar insertion hole 27 of the motor housing 21, the bus bar insertion hole 44 of the bottom plate 41, and the bus bar insertion hole 34 of the substrate 31, and an upper end of the bus bar 6 protrudes upward beyond the substrate 31. The bus bar 6 is connected to the wiring formed on the first principal surface 31a of the substrate 31.

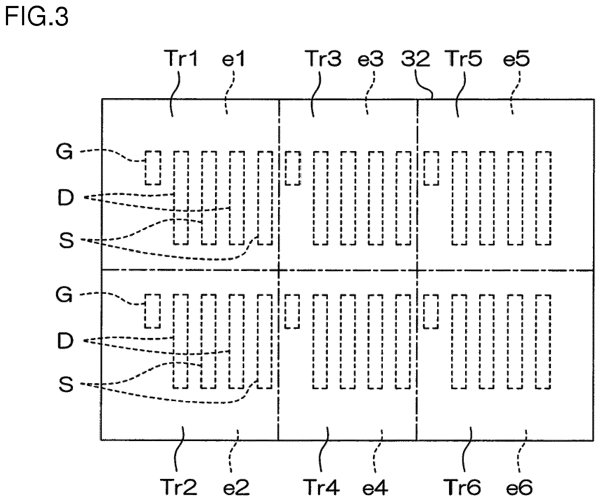

FIG. 3 is a plan view, as seen from the no-electrode surface side, of the electrodes formed on the electrode surface of the horizontal semiconductor chip 32. The horizontal semiconductor chip 32 has a rectangular shape in a plan view. The six switching elements Tr1 to Tr6 are formed respectively in six divided regions e1 to e6 that are defined by dividing the horizontal semiconductor chip 32 into two parts in a short-side direction and three parts in a long-side direction in a plan view. The electrodes of the six switching elements Tr1 to Tr6 are formed on the electrode surface 32a of the horizontal semiconductor chip 32.

Each switching element Tr1 to Tr6 has two drain electrodes D, two source electrodes S, and one gate electrode G in the corresponding divided region e1 to e6. In a plan view, the drain electrodes D and the source electrodes S each have a strip shape that is long in the short-side direction of the horizontal semiconductor chip 32. The gate electrode G has a strip shape that is long in the short-side direction of the horizontal semiconductor chip 32 and has a length not larger than half the length of the drain electrode D. In each of the divided regions e1 to e6, the two drain electrodes D and the two source electrodes S are arrayed alternately at regular intervals in the long-side direction of the horizontal semiconductor chip 32. The one gate electrode G is disposed outside the drain electrode D that is located at one end of the row of these four electrodes, so as to extend along one end of this drain electrode D.

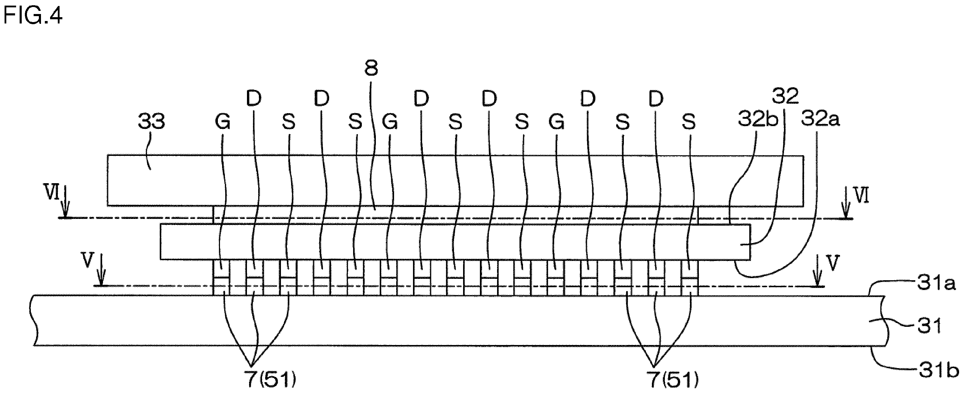

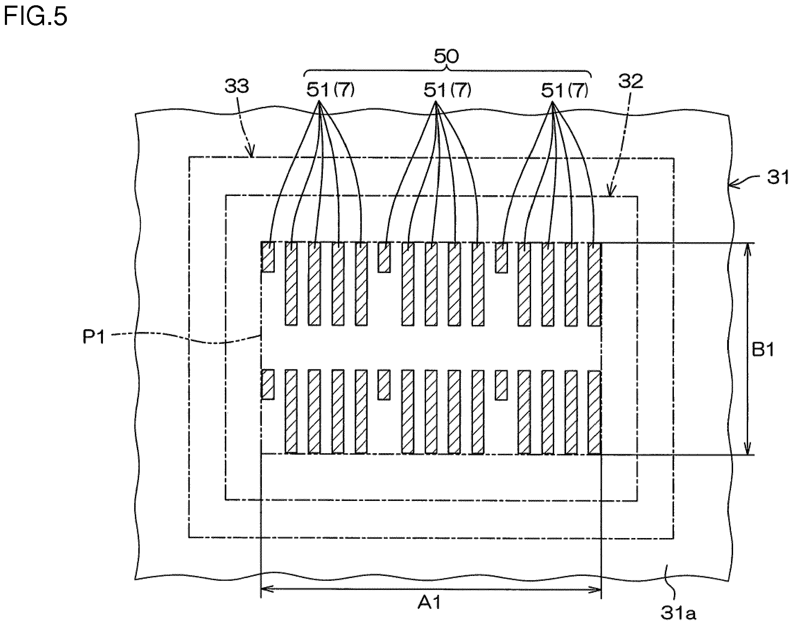

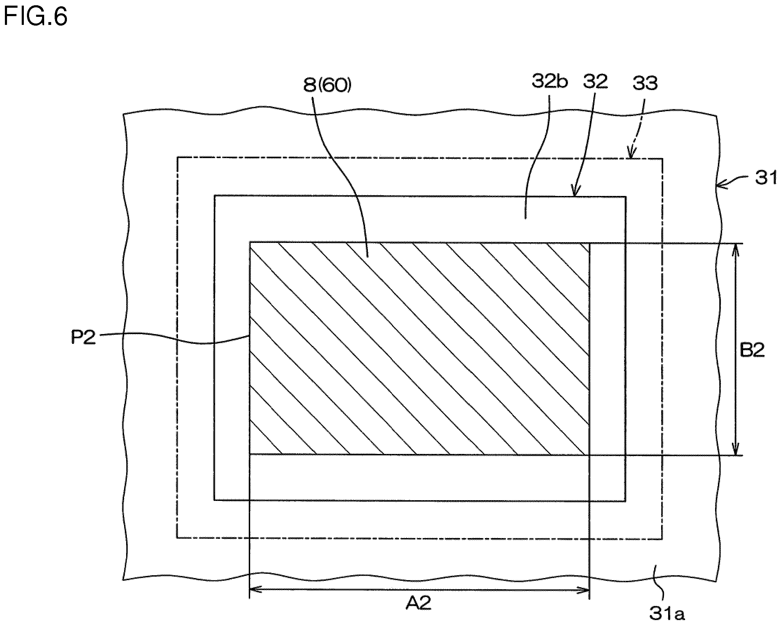

FIG. 4 is an enlarged front view showing a joint structure of the substrate 31 and the horizontal semiconductor chip 32 and a joint structure of the horizontal semiconductor chip 32 and the heatsink 33. FIG. 5 is a sectional view taken along the line V-V of FIG. 4. FIG. 6 is a sectional view taken along the line VI-VI of FIG. 4. The horizontal semiconductor chip 32 is mounted on the substrate 31 as the electrodes D, S, G are joined to the wiring on the first principal surface 31a of the substrate 31 through solder (joining member) 7. Thus, the plurality of electrodes D, S, G and the substrate 31 are electrically connected to each other through the solder 7. Joint portions at which the electrodes D, S, G and the substrate 31 are electrically and mechanically joined together through the solder 7 will be referred to as electrical-mechanical joint portions 51. Joint portions at which the electrode surface 32a and the substrate 31 are joined together will be referred to as first joint portions 50. In this embodiment, the first joint portions 50 are composed of the electrical-mechanical joint portions 51.

In a plan view, a region inside the outline of the rough overall shape of an aggregate of the first joint portions 50 will be referred to as a first joint region P1. As shown in FIG. 5, in a plan view, the first joint region P1 in this embodiment is a region of the electrode surface 32a of the horizontal semiconductor chip 32 except for a peripheral edge portion, and is a region having a rectangular shape substantially similar to the shape of the electrode surface 32a. The first joint region P1 is also a region enclosed by straight lines connecting outer sides of the outermost joint portions 50 of the first joint portions 50. The size of the first joint region P1 is defined by a length A1 in a long-side direction and a length B1 in a short-side direction.

As indicated by the dashed-dotted line in FIG. 6, the heatsink 33 has a rectangular shape and is larger than the horizontal semiconductor chip 32 in a plan view. The heatsink 33 is joined to the no-electrode surface 32b of the horizontal semiconductor chip 32 through solder (thermally conductive joining member) 8. Thus, the no-electrode surface 32b and the heatsink 33 are thermally connected to each other through the solder 8. A joint portion at which the no-electrode surface 32b and the heatsink 33 are joined together through the solder 8 will be referred to as a second joint portion 60. In a plan view, a region inside the outline of the second joint portion 60 will be referred to as a second joint region P2. As shown in FIG. 6, in a plan view, the second joint region P2 is a region of the no-electrode surface 32b except for a peripheral edge portion, and is a region having a rectangular shape substantially similar to the shape of the no-electrode surface 32b. As shown in FIG. 6, the size of the second joint region P2 is defined by a length A2 in a long-side direction and a length B2 in a short-side direction.

In this embodiment, the first joint region P1 and the second joint region P2 are the same in position, shape, and size (or position and outermost shape) in a plan view. Thus, A1 equals A2, and B1 equals B2. Relative to the direction normal to the principal surfaces 31a, 31b of the substrate 31 (up-down direction), the first joint region P1 and the second joint region P2 coincide with each other. The linear thermal expansion coefficients of the substrate 31 and the heatsink 33 are substantially equal. The linear thermal expansion coefficient of the horizontal semiconductor chip 32 is smaller than the linear thermal expansion coefficients of the substrate 31 and the heatsink 33. The linear thermal expansion coefficients of the substrate 31 and the heatsink 33 are about 16 ppm, for example, while the linear thermal expansion coefficient of the horizontal semiconductor chip 32 is about 4 ppm, for example. Accordingly, when the temperatures of the substrate 31 and the heatsink 33 are risen by the heat of the horizontal semiconductor chip 32, a tensile force is exerted by the heatsink 33 on the no-electrode surface 32b of the horizontal semiconductor chip 32, while a tensile force is exerted by the substrate 31 on the electrode surface 32a of the horizontal semiconductor chip 32. When there is a difference between these tensile forces, the horizontal semiconductor chip 32 warps. This warping causes stress on the joint portions 50 between the horizontal semiconductor chip 32 and the substrate 31 and on the joint portion 60 between the horizontal semiconductor chip 32 and the heatsink 33, which may result in connection failure (joint failure).

In the first embodiment described above, the first joint region P1 and the second joint region P2 are the same in position, shape, and size (or position and outermost shape) in a plan view. Accordingly, the tensile forces acting on the no-electrode surface 32b and the electrode surface 32a of the horizontal semiconductor chip 32 are substantially equal. Thus, warping of the horizontal semiconductor chip 32 can be suppressed. As a result, it is possible to prevent connection failure (joint failure) at the first joint portions 50 (electrical-mechanical joint portions 51 (7)) between the horizontal semiconductor chip 32 and the substrate 31 and the second joint portion 60 (8) between the horizontal semiconductor chip 32 and the heatsink 33.

In the first embodiment described above, as shown in FIG. 5, there is a space among the electrical-mechanical joint portions 51 inside the first joint region P1 between the electrode surface 32a of the horizontal semiconductor chip 32 and the substrate 31. From the viewpoint of equalizing the tensile forces acting on the no-electrode surface 32b and the electrode surface 32a of the horizontal semiconductor chip 32, it is preferable that joint portions also be provided in this space among the electrical-mechanical joint portions 51 inside the first joint region P1.

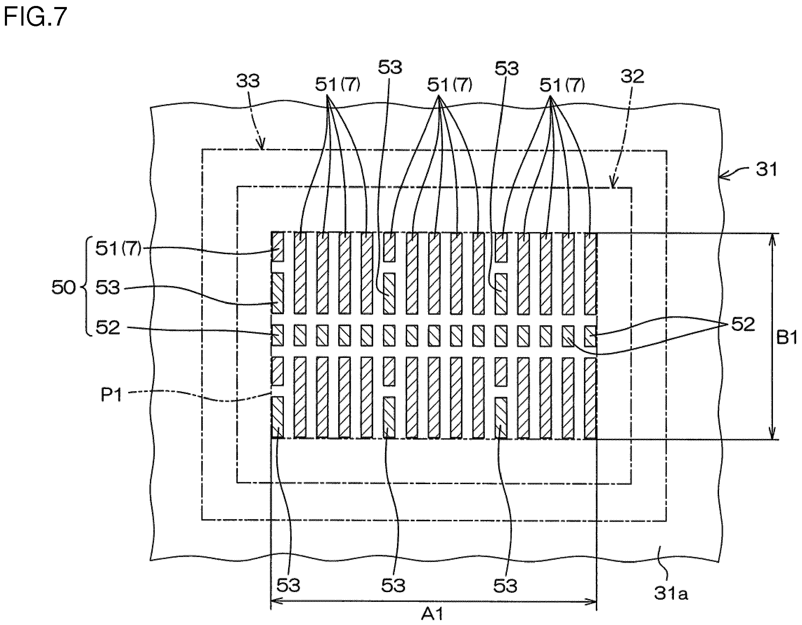

Therefore, as shown in FIG. 7, it is preferable that dummy joint portions that simply mechanically join together the electrode surface 32a and the substrate 31, without electrically connecting the electrodes D, S, G to the substrate 31, be formed in the space among the electrical-mechanical joint portions 51 inside the first joint region P1. FIG. 7 is a sectional view corresponding to FIG. 5. Specifically, in a plan view, quadrangular first dummy joint portions 52 are provided at intervals in the long-side direction, at a center portion of the first joint region P1 in a width direction. In a plan view, quadrangular second dummy joint portions 53 are each provided on a line extended from the gate electrode G, along the drain electrode D adjacent to the gate electrode G. Thus, in FIG. 7, the first joint portions 50 are composed of the electrical-mechanical joint portions 51, the first dummy joint portions 52, and the second dummy joint portions 53.

For example, the dummy joint portions 52, 53 are formed as follows: A dummy wire (a wire that is not electrically connected to the inverter circuit 100) corresponding to each of the dummy joint portions 52, 53 is formed on the first principal surface 31a of the substrate 31. A dummy electrode (an electrode that does not function as an electrode of a switching element) corresponding to each of the dummy joint portions 52, 53 is formed on the electrode surface 32a of the horizontal semiconductor chip 32. The dummy wire and the corresponding dummy electrode then are joined together through solder.

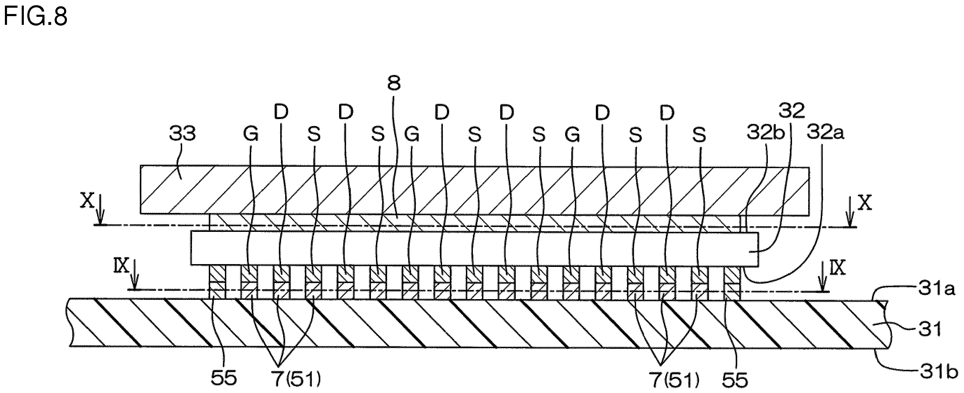

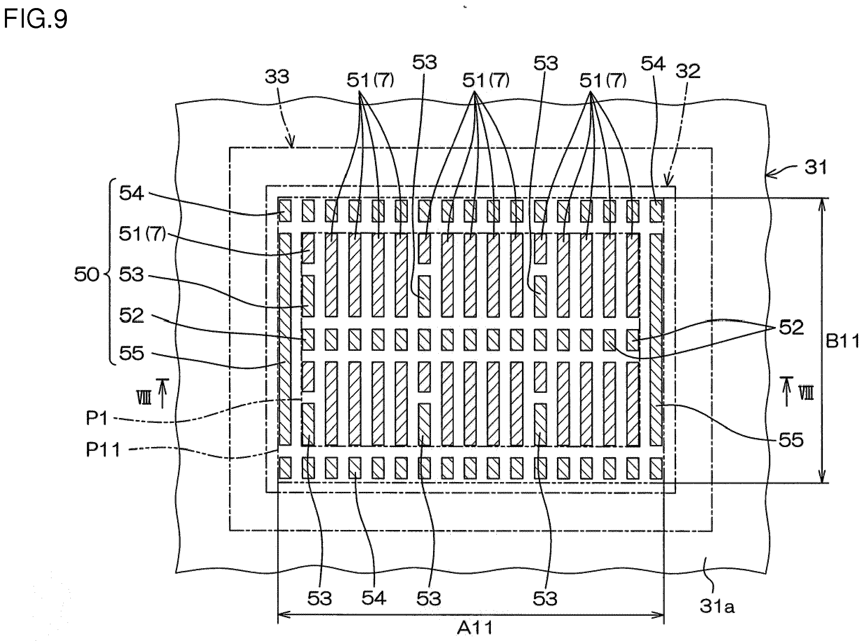

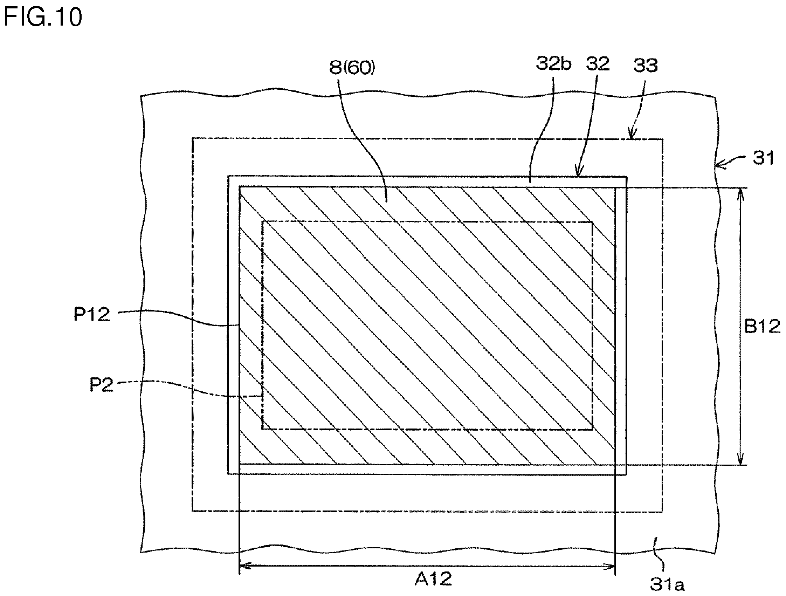

FIG. 8 is an enlarged sectional view, taken along the line VIII-VIII of FIG 9, showing a modified example of the joint structure of the substrate 31 and the horizontal semiconductor chip 32 and the joint structure of the horizontal semiconductor chip 32 and the heatsink 33. FIG. 9 is a sectional view taken along the line IX-IX of FIG. 8. FIG. 10 is a sectional view taken along the line X-X of FIG. 8. Those parts in FIG. 8 to FIG. 10 that correspond to the parts in FIG. 4 to FIG. 6 described above will be denoted by the same reference signs as in FIG. 4 to FIG. 6.

In the joint structure of FIG. 8, as shown in FIG. 9, dummy joint portions are formed not only in an electrode group region (a region corresponding to the first joint region P1 of FIG. 5) but also outside the electrode group region in the electrode surface 32a of the horizontal semiconductor chip 32. As in FIG. 7 described above, the first and second dummy joint portions 52, 53 are formed in the electrode group region (P1). Third dummy joint portions 54 are disposed outside the electrode group region (P1), at intervals along each long side of the electrode group region (P1). The third dummy joint portions 54 each have a quadrangular shape in a plan view. Fourth dummy joint portions 55 are disposed outside the electrode group region (P1), respectively along the short sides of the electrode group region (P1). The fourth dummy joint portions 55 each have a belt shape extending parallel to the short side of the electrode group region (P1) in a plan view. Thus, in the joint structure of FIG. 8, the first joint portions 50 are composed of the electrical-mechanical joint portions 51, the first dummy joint portions 52, the second dummy joint portions 53, the third dummy joint portions 54, and the fourth dummy joint portions 55. Accordingly, in the joint structure of FIG. 8, a substantially rectangular region including the electrode group region (P1) and the dummy joint portions 54, 55 disposed outside the region in a plan view constitutes a first joint region P11. As shown in FIG. 9, the size of the first joint region P11 is defined by a length A11 in a long-side direction and a length B11 in a short-side direction. The third and fourth dummy joint portions 54, 55 can be formed by the same method as the first and second dummy joint portions 52, 53.

The electrode surface 32a of the horizontal semiconductor chip 32 is joined to the substrate 31 through the electrical-mechanical joint portions 51 and the first to fourth dummy joint portions 52 to 55. The heatsink 33 is joined to the no-electrode surface 32b of the horizontal semiconductor chip 32 through the solder 8. The joint portion at which the no-electrode surface 32b and the heatsink 33 are joined together through the solder 8 will be referred to as the second joint portion 60. In a plan view, a region inside the outline of the second joint portion 60 will be referred to as a second joint region P12. As shown in FIG. 10, the size of the second joint region P12 is defined by a length A12 in a long-side direction and a length B 12 in a short-side direction.

In this modified example, the first joint region P11 and the second joint region P12 are the same in position, shape, and size (or position and outermost shape) in a plan view. Thus, A11 equals A12, and B11 equals B12. Relative to the direction normal to the principal surfaces 31a, 31b of the substrate 31 (up-down direction), the first joint region P11 and the second joint region P12 coincide with each other. Accordingly, this modified example offers advantages similar to those of the first embodiment described above. In this modified example, the joint region P12 of the no-electrode surface 32b of the horizontal semiconductor chip 32 and the heatsink 33 is larger than the joint region P2 in the first embodiment described above. Thus, the efficiency of thermal conduction between the no-electrode surface 32b and the heatsink 33 can be enhanced.

While the embodiment of the present invention has been described above, the invention can also be implemented in other forms. For example, in the first embodiment described above, the example where the horizontal semiconductor chip 32 including the six switching elements Tr1 to Tr6 is used has been described. However, each of the switching elements Tr1 to Tr6 may be composed of a horizontal semiconductor chip 35 (horizontal semiconductor element). In this case, six horizontal semiconductor chips 35 are mounted on the first principal surface 31a of the substrate 31.

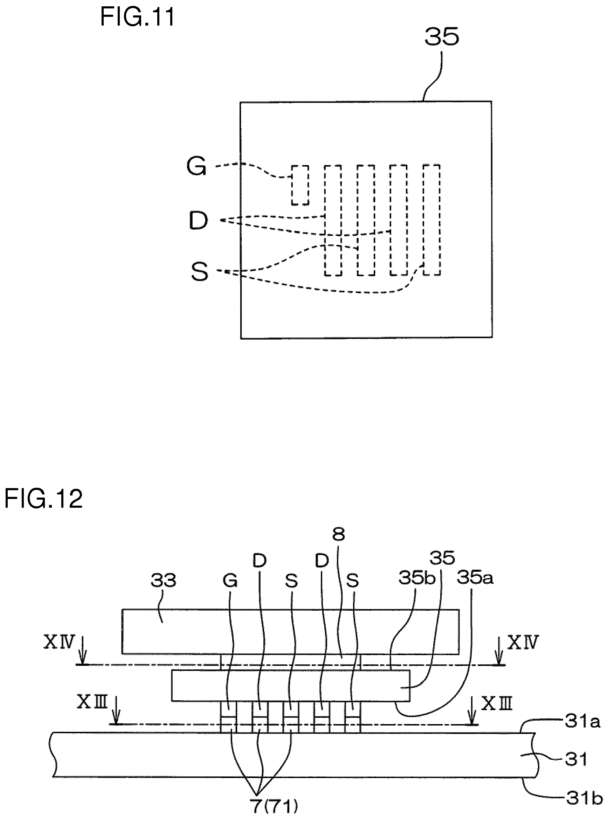

An embodiment (second embodiment) will be described below in which the horizontal semiconductor chip is composed of one switching element. FIG. 11 is a plan view, as seen from a no-electrode surface side, of electrodes formed on an electrode surface of the horizontal semiconductor chip 35 that is composed of one switching element. The horizontal semiconductor chip 35 has a rectangular shape in a plan view. Two drain electrodes D, two source electrodes S, and one gate electrode G are formed on the electrode surface of the horizontal semiconductor chip 35. In a plan view, the drain electrodes D and the source electrodes S each have a strip shape that is long in a short-side direction of the electrode surface. The gate electrode G has a strip shape that is long in the short-side direction of the electrode surface and has a length not larger than half the length of the drain electrode D. The two drain electrodes D and the two source electrodes S are arrayed alternately at regular intervals in a long-side direction of the electrode surface. The gate electrode G is disposed outside the drain electrode D that is located at one end of the row of these four electrodes, so as to extend along one end of this drain electrode D.

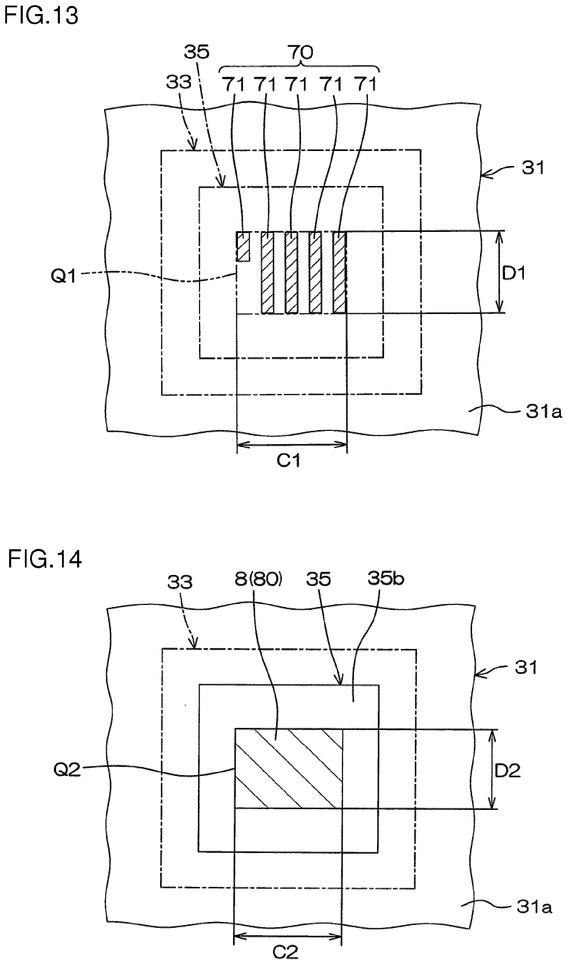

FIG. 12 is an enlarged front view showing a joint structure of the substrate 31 and the horizontal semiconductor chip 35 and a joint structure of the horizontal semiconductor chip 35 and the heatsink 33. FIG. 13 is a sectional view taken along the line XIII-XIII of FIG. 12. FIG. 14 is a sectional view taken along the line XIV-XIV of FIG. 12. The horizontal semiconductor chip 35 is mounted on the substrate 31 as the electrodes D, S, G are joined to the wiring on the first principal surface 31a of the substrate 31 through the solder 7. Thus, the plurality of electrodes D, S, G and the substrate 31 are electrically connected to each other through the solder 7. Joint portions at which the electrodes D, S, G and the substrate 31 are electrically and mechanically joined together through the solder 7 will be referred to as electrical-mechanical joint portions 71. Joint portions at which the electrode surface 35a and the substrate 31 are joined together will be referred to as first joint portions 70. In this embodiment, the first joint portions 70 are composed of the electrical-mechanical joint portions 71.

In a plan view, a region inside the outline of the rough overall shape of an aggregate of the first joint portions 70 will be referred to as a first joint region Q1. As shown in FIG. 13, in a plan view, the first joint region Q1 in this embodiment is a region of the electrode surface 35a of the horizontal semiconductor chip 35 except for a peripheral edge portion, and is a region having a rectangular shape substantially similar to the shape of the electrode surface 35a. The first joint region Q1 is a region enclosed by straight lines connecting outer sides of the outermost joint portions 70 of the first joint portions 70. The size of the first joint region Q1 is defined by a length C1 in a long-side direction and a length D1 in a short-side direction.

As indicated by the dashed-dotted line in FIG. 14, the heatsink 33 has a rectangular shape and is larger than the horizontal semiconductor chip 35 in a plan view. The heatsink 33 is joined to a no-electrode surface 35b of the horizontal semiconductor chip 35 through the solder 8. Thus, the no-electrode surface 35b and the heatsink 33 are thermally connected to each other through the solder 8. A joint portion at which the no-electrode surface 35b and the heatsink 33 are joined together through the solder 8 will be referred to as a second joint portion 80. In a plan view, a region inside the outline of the second joint portion 80 will be referred to as a second joint region Q2. As shown in FIG. 14, in a plan view, the second joint region Q2 is a region of the no-electrode surface 35b except for a peripheral edge portion, and is a region having a rectangular shape substantially similar to the shape of the no-electrode surface 35b. The size of the second joint region Q2 is defined by a length C2 in a long-side direction and a length D2 in a short-side direction.

In this embodiment, the first joint region Q1 and the second joint region Q2 are the same in position, shape, and size (or position and outermost shape) in a plan view. Thus, C1 equals C2, and D1 equals D2. Relative to the direction normal to the principal surfaces 31a, 31b of the substrate 31 (up-down direction), the first joint region Q1 and the second joint region Q2 coincide with each other. The linear thermal expansion coefficients of the substrate 31 and the heatsink 33 are substantially equal. The linear thermal expansion coefficient of the horizontal semiconductor chip 35 is smaller than the linear thermal expansion coefficients of the substrate 31 and the heatsink 33. Accordingly, when the temperatures of the substrate 31 and the heatsink 33 are risen by the heat of the horizontal semiconductor chip 35, a tensile force is exerted by the heatsink 33 on the no-electrode surface 35b of the horizontal semiconductor chip 35, while a tensile force is exerted by the substrate 31 on the electrode surface 35a of the horizontal semiconductor chip 35. When there is a difference between these tensile forces, the horizontal semiconductor chip 35 warps. This warping causes stress on the joint portions 70 between the horizontal semiconductor chip 35 and the substrate 31 and on the joint portion 80 between the horizontal semiconductor chip 35 and the heatsink 33, which may result in connection failure (joint failure).

In the second embodiment described above, the first joint region Q1 and the second joint region Q2 are the same in position, shape, and size (or position and outermost shape) in a plan view. Accordingly, the tensile forces acting on the no-electrode surface 35b and the electrode surface 35a of the horizontal semiconductor chip 35 are substantially equal. Thus, warping of the horizontal semiconductor chip 35 can be suppressed. As a result, it is possible to prevent connection failure (joint failure) at the first joint portions 70 (electrical-mechanical joint portions 71 (7)) between the horizontal semiconductor chip 35 and the substrate 31 and at the second joint portion 80 (8) between the horizontal semiconductor chip 35 and the heatsink 33.

As shown in FIG. 13, in the second embodiment described above, there is a space among the plurality of electrical-mechanical joint portions 71 inside the first joint region Q1 between the electrode surface 35a of the horizontal semiconductor chip 35 and the substrate 31. From the viewpoint of equalizing the tensile forces acting on the no-electrode surface 35b and the electrode surface 35a of the horizontal semiconductor chip 35, it is preferable that joint portions also be provided in this space among the electrical-mechanical joint portions 71 inside the first joint region Q1.

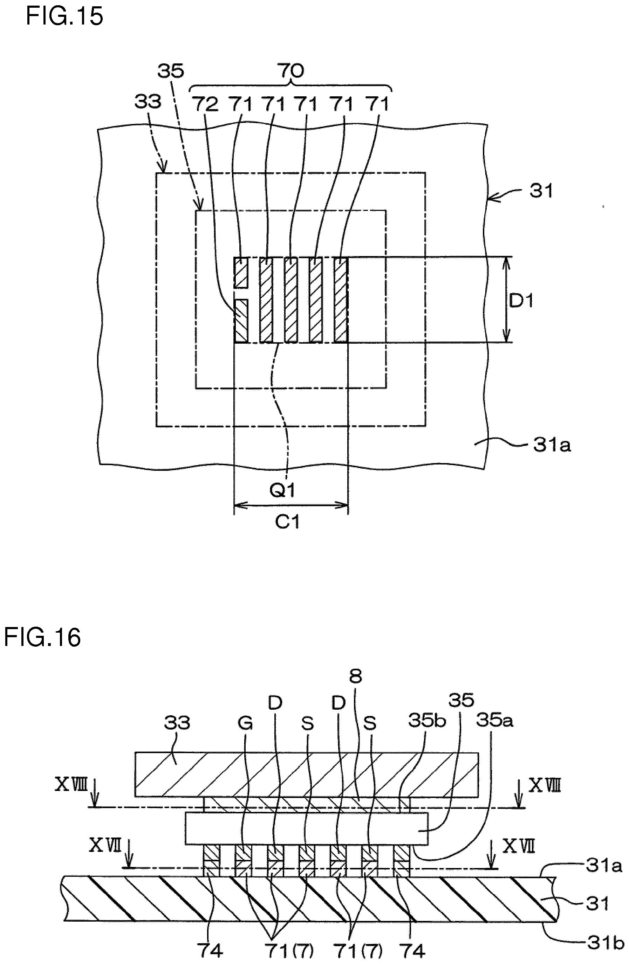

Therefore, as shown in FIG. 15, it is preferable that dummy joint portions that simply mechanically join together the electrode surface 35a and the substrate 31, without electrically connecting the electrodes D, S, G to the substrate 31, be formed in the space among the electrical-mechanical joint portions 71 inside the first joint region Q1. Specifically, in a plan view, a quadrangular first dummy joint portion 72 is provided on a line extended from the gate electrode G, along the drain electrode D adjacent to the gate electrode G. Thus, in FIG. 15, the first joint portions 70 are composed of the electrical-mechanical joint portions 71 and the first dummy joint portion 72.

For example, the first dummy joint portion 72 is formed as follows: A dummy wire (a wire that is not electrically connected to the inverter circuit 100) corresponding to the first dummy joint portion 72 is formed on the first principal surface 31a of the substrate 31. A dummy electrode (an electrode that does not function as an electrode of a switching element) corresponding to the first dummy joint portion 72 is formed on the electrode surface 35a of the horizontal semiconductor chip 35. The dummy wire and the corresponding dummy electrode then are joined together through solder.

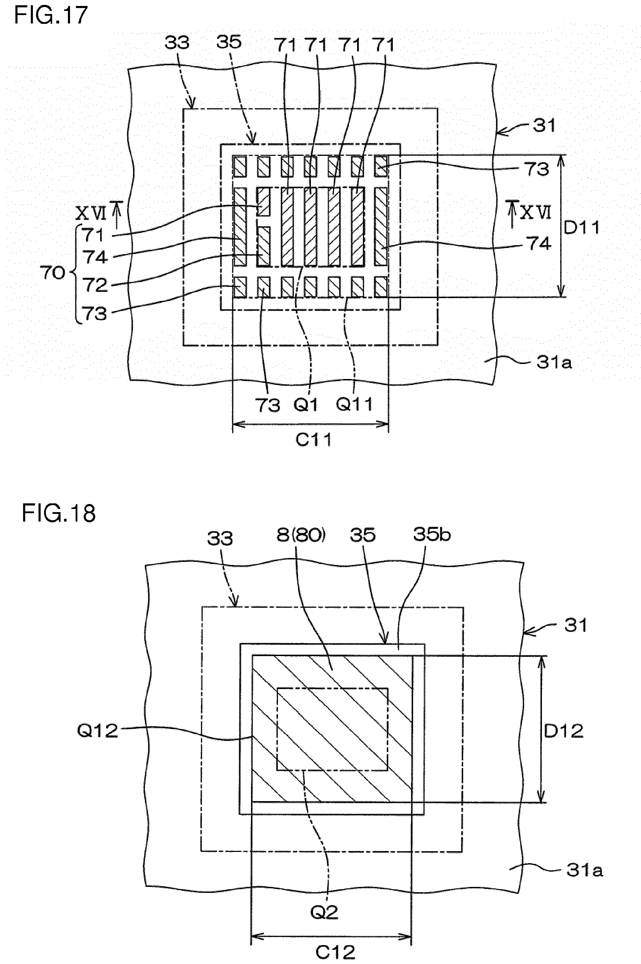

FIG. 16 is an enlarged sectional view, taken along the line XVI-XVI of FIG. 17, showing a modified example of the joint structure of the substrate 31 and the horizontal semiconductor chip 35 and the joint structure of the horizontal semiconductor chip 35 and the heatsink 33. FIG. 17 is a sectional view taken along the line XVII-XVII of FIG. 16. FIG. 18 is a sectional view taken along the line XVIII-XVIII of FIG. 16. Those parts in FIG. 16 to FIG. 18 that correspond to the parts in FIG. 12 to FIG. 14 described above will be denoted by the same reference signs as in FIG. 12 to FIG. 14.

In the joint structure of FIG. 16, as shown in FIG. 17, dummy joint portions are formed not only in an electrode group region (a region corresponding to the first joint region Q1 of FIG. 13) but also outside the electrode group region in the electrode surface 35a of the horizontal semiconductor chip 35. As in FIG. 15 described above, the first dummy joint portion 72 is formed in the electrode group region (Q1). Second dummy joint portions 73 are disposed outside the electrode group region (Q1), at intervals along each long side of the electrode group region (Q1). The second dummy joint portions 73 each have a quadrangular shape in a plan view. Moreover, third dummy joint portions 74 are disposed outside the electrode group region (Q1), respectively along the short sides of the electrode group region (Q1). The third dummy joint portions 74 each have a belt shape extending parallel to the short side of the electrode group region (Q1) in a plan view. Thus, in the joint structure of FIG. 16, the first joint portions 70 are composed of the electrical-mechanical joint portions 71, the first dummy joint portion 72, the second dummy joint portions 73, and the third dummy joint portions 74. Accordingly, in the joint structure of FIG. 16, in a plan view, a substantially rectangular region including the electrode group region (Q1) and the dummy joint portions 73, 74 outside thereof constitutes a first joint region Q11. As shown in FIG. 17, the size of the first joint region Q11 is defined by a length C11 in a long-side direction and a length D11 in a short-side direction. The second and third dummy joint portions 73, 74 can be formed by the same method as the first dummy joint portion 72.

The electrode surface 35a of the horizontal semiconductor chip 35 is joined to the substrate 31 through the electrical-mechanical joint portions 71 and the first to third dummy joint portions 72 to 74. The heatsink 33 is joined to the no-electrode surface 35b of the horizontal semiconductor chip 35 through the solder 8. The joint portion at which the no-electrode surface 35b and the heatsink 33 are joined together through the solder 8 will be referred to as the second joint portion 80. In a plan view, a region inside the outline of the second joint portion 80 will be referred to as a second joint region Q12. As shown in FIG. 18, the size of the second joint region Q12 is defined by a length C12 in a long-side direction and a length D12 in a short-side direction.

In this modified example, the first joint region Q11 and the second joint region Q12 are the same in position, shape, and size (or position and outermost shape) in a plan view. Thus, C11 equals C12, and D11 equals D12. Relative to the direction normal to the principal surfaces 31a, 31b of the substrate 31 (up-down direction), the first joint region Q11 and the second joint region Q12 coincide with each other. Accordingly, this modified example offers advantages similar to those of the second embodiment described above. In this modified example, the joint region Q12 of the no-electrode surface 35b of the horizontal semiconductor chip 35 and the heatsink 33 is larger than the joint region Q2 in the embodiment described above. Thus, the efficiency of thermal conduction between the no-electrode surface 35b and the heatsink 33 can be enhanced.

In the first and second embodiments described above, solder is used to join together the horizontal semiconductor chips 32, 35 and the substrate 31 and to join together the horizontal semiconductor chips 32, 35 and the heatsink 33. However, joining members other than solder may be used to join these components. Plating may be used to join together the horizontal semiconductor chips 32, 35 and the substrate 31 or to join together the horizontal semiconductor chips 32, 35 and the heatsink 33. Diffusion bonding may be used to join together the horizontal semiconductor chips 32, 35 and the substrate 31 or to join together the horizontal semiconductor chips 32, 35 and the heatsink 33.

The first joint regions P1, P11, Q1, Q11 and the second joint regions P2, P12, Q2, Q12 each have a rectangular shape in a plan view in the embodiments and the modified examples described above, but these regions may instead have a square shape in a plan view. While the case where the present invention is applied to an inverter circuit of an electric power steering system has been described, the invention can also be applied to an inverter circuit etc. that are used for other applications than an electric power steering system.

Various design changes can be otherwise made within the scope of the items described in the claims.

## Claims

1. A semiconductor device comprising:
a substrate;
a horizontal semiconductor chip that has an electrode surface on which a plurality of electrodes are provided and a no-electrode surface which is a surface on the opposite side from the electrode surface and on which no electrodes are provided, the horizontal semiconductor chip being joined to the substrate with the electrode surface facing one surface of the substrate; and
a heat dissipation member which is disposed on the opposite side of the horizontal semiconductor chip from the substrate, and to which at least a part of the no-electrode surface of the horizontal semiconductor chip is joined, wherein
the electrode surface and the substrate are joined together through a plurality of first joint portions including at least a plurality of joint portions at which the electrodes formed on the electrode surface are joined to the substrate,
the no-electrode surface and the heat dissipation member are joined together through a second joint portion at which the no-electrode surface and the heat dissipation member are joined together, and
in a plan view from a direction normal to a principal surface of the substrate, when a region inside an outline of a rough overall shape of an aggregate of the first joint portions is a first joint region and a region inside an outline of the second joint portion is a second joint region, the first joint region and the second joint region are the same in position, shape, and size.

2. The semiconductor device according to claim 1, wherein
the substrate has circuit wiring formed thereon, and
the first joint portions include a plurality of joint portions at which a number of the electrodes are respectively joined to the substrate so as to be electrically connected thereto, and one or more dummy joint portions at which the electrode surface and the substrate are joined together so that the remainder of the electrodes is not electrically connected to the circuit wiring of the substrate.

3. The semiconductor device according to claim 1 or 2, wherein the horizontal semiconductor chip includes a plurality of switching elements.

4. The semiconductor device according to claim 1 or 2, wherein the horizontal semiconductor chip is composed of one switching element.
